Europäisches Patentamt

European Patent Office

Office européen des brevets

(11) Veröffentlichungsnummer: **0 382 194**

**A1**

(12) **EUROPÄISCHE PATENTANMELDUNG**

(21) Anmeldenummer: 90102420.8

(51) Int. Cl.5: **C25D 13/02, H01L 39/24**

(22) Anmeldetag: 07.02.90

(30) Priorität: 08.02.89 DE 3903728

(43) Veröffentlichungstag der Anmeldung:
16.08.90 Patentblatt 90/33

(84) Benannte Vertragsstaaten:
AT BE CH DE DK ES FR GB GR IT LI LU NL SE

(71) Anmelder: INTERATOM Gesellschaft mit
beschränkter Haftung
Friedrich-Ebert-Strasse
D-5060 Bergisch-Gladbach 1(DE)

(72) Erfinder: Becks, Martinus
Stollwerkhof 1
D-5000 Köln 1(DE)
Erfinder: Hein, Matthias, Dipl.-Phys.
Weyersberger Strasse 76
D-5650 Solingen 1(DE)
Erfinder: Müller, Günter, Dr.
Am Cleefkothen 14
D-5600 Wuppertal 1(DE)
Erfinder: Ponto, Ludwik, Dr.
Bergische Universität, Postfach 10 01 27
D-5600 Wuppertal(DE)

(74) Vertreter: Fuchs, Franz-Josef, Dr.-Ing. et al
Postfach 22 13 17
D-8000 München 22(DE)

(54) Elektrophoretische Abscheidung einer supraleitfähigen Schicht unter Einfluss eines externen Magnetfeldes.

(57) Die Erfindung betrifft ein Verfahren zur elektrophoretischen Abscheidung einer supraleitfähigen keramischen Schicht aus einem feingemahlenen Material, insbesondere einer $YBa_2Cu_3O_{7-x}$-Schicht, auf einer elektrisch leitfähigen, vorzugsweise metallischen Oberfläche, wobei die Schicht anschließend in oxidierender Atmosphäre gesintert und abgekühlt wird, wobei das Material unter Einfluß eines äußeren Magnetfeldes auf der Oberfläche abgeschieden wird. Durch die Abscheidung in einem Magnetfeld wird eine Vorzugsorientierung der Kristallachsen der abgeschiedenen Teilchen erreicht; insbesondere werden die c-Achsen der Teilchen parallel zum Magnetfeld ausgerichtet. Die durch die Ausrichtung der Kristallachsen bedingte Texturierung der keramischen Schicht ermöglicht eine Verbesserung der elektrischen Leitfähigkeit und eine Verbesserung des Verhaltens im Magnetfeld im Vergleich zu nicht-texturierten Schichten.

## Elektrophoretische Abscheidung einer supraleitfähigen Schicht unter Einfluß eines externen Magnetfeldes

Die vorliegende Erfindung betrifft ein Verfahren zur Abscheidung einer supraleitfähigen keramischen Schicht auf einer elektrisch leitfähigen Oberfläche sowie eine entsprechende supraleitfähige Schicht.

Als supraleitfähiges keramisches Material im Sinne der vorliegenden Erfindung sind geeignet die Verbindungen $YBa_2 Cu_3 O_{7-x}$ und ähnliche Metall-Verbindungen, bei denen Y (Yttrium) durch andere Seltene Erden (wie Eu, Er, Gd etc.) substituiert ist sowie oxidische Bi/Tl-Sr/Ba-Ca-Cu-O-Verbindungen geeigneter Metallstöchiometrien, z. B. 2-2-1-2 oder 2-2-2-3. Von Verbindungen dieser Art ist bekannt, daß sie bei Temperaturen von 80 - 120 K supraleitend werden.

In der DE-OS 21 10 520 wird "ein Verfahren zum Herstellen von einen Überzug aufweisenden zementierten Karbidgegenständen" beschrieben, bei dem ein feines Pulver aus Titan-Karbid elektrophoretisch in organischer Flüssigkeit mit einer Gleichspannung von 10 - 100 Volt aufgetragen und anschließend im Vakuum oder in reduzierender bzw. inerter Atmosphäre gesintert wird.

In der japanischen Patentanmeldung 61-150222 Appl. No 59-272 604 wird angegeben, glasartige Stoffe feingemahlen kataphoretisch oder durch Zentrifugal-Sedimentation in einer organischen Flüssigkeit aufzutragen, wobei die verschiedenen Bestandteile gemischt und bei hohen Temperaturen in einer oxidierenden Atmosphäre aufgeschmolzen werden.

In der US-PS 3 466 237 wird angegeben, supraleitende Überzüge aus Zinn auf Niob elektrophoretisch in organischer Flüssigkeit aufzutragen, wobei diese Schicht anschließend in einer nicht oxidierenden Atmosphäre erhitzt wird.

In der EP-A-0 311 804 (nicht vorveröffentlicht) hat die Anmelderin ein elektrophoretisches Verfahren zur Herstellung supraleitender Schichten aus einem keramischen Material auf elektrisch leitenden Oberflächen vorgeschlagen, bei dem das Material in feingemahlener Form in einer nicht wässerigen Suspension kataphoretisch aufgetragen, getrocknet und in oxidierender Atmosphäre gesintert wird. In dieser Schrift wird die Elektrophorese ausführlich dargestellt. Weitere Ausführungen zur Anwendung der Elektrophorese im Zusammenhang mit keramischen Supraleitern sind dem Aufsatz: H. Piel et al., "Superconducting Perovskites in Microwave Fields", Physica C 1988, Seite 153 ff., entnehmbar.

Eine Vorzugsorientierung der Schichtteilchen wurde bislang weder angestrebt noch verwirklicht. Messungen der Transportstromdichte und der magnetischen Abschirmung haben gezeigt, daß das elektrophoretische Verfahren im Gegensatz zu anderen Depositionstechniken (wie z. B. Plasmaspritzen oder Sprayverfahren) die Herstellung makroskopisch zusammenhängender supraleitfähiger Oberflächenbereiche ermöglicht. Darüber hinaus sind die Hochfrequenzverluste entsprechender $YBa_2Cu_3O_{7-x}$-Schichten z. B. bei der anwendungstechnisch relevanten Temperatur von 77 K bis zu einer Frequenz von etwa 20 GHz signifikant niedriger als die von Kupfer. Diese Eigenschaften sowie die Beschichtbarkeit beliebig großer und auch gekrümmter Substrate weisen diesem Verfahren ein besonderes Anwendungspotential aus.

Aufgabe der vorliegenden Erfindung ist die Schaffung eines Verfahrens zur Abscheidung einer supraleitfähigen keramischen Schicht auf einer elektrisch leitfähigen Oberfläche, bei dem die Schichtteilchen eine Vorzugsorientierung ihrer c-Achse aufweisen, sowie die Schaffung einer entsprechenden Schicht. Dadurch sollen die elektrischen Eigenschaften der Schicht verbessert werden, insbesondere im Hinblick auf die Reduktion von Hochfrequenzverlusten und die Steigerung maximal erreichbarer Stromdichten.

Zur Lösung dieser Aufgabe dient ein Verfahren zur elektrophoretischen Abscheidung einer supraleitfähigen keramischen Schicht aus einem feingemahlenen Material, insbesondere einer $YBa_2Cu_3O_{7-x}$-Schicht, auf einer elektrisch leitfähigen, vorzugsweise metallischen Oberfläche, wobei die Schicht anschließend in oxidierender Atmosphäre gesintert und abgekühlt wird, wobei erfindungsgemäß das Material unter Einfluß eines äußeren Magnetfeldes auf der Oberfläche abgeschieden wird.

Gegenstand der Erfindung ist auch eine supraleitfähige keramische Schicht, insbesondere bestehend aus $YBa_2Cu_3O_{7-x}$ oder einem ähnlichen Material, auf einem Substrat, wobei die die Schicht bildenden Teilchen eine Vorzugsorientierung ihrer c-Achsen aufweisen. Das Substrat kann dabei, je nach Anwendung, eben oder gekrümmt sein; als Substrat kommt vor allem Silber, aber auch Kupfer in Frage.

Es hat sich gezeigt, daß gemäß der vorliegenden Erfindung hergestellte Schichten eine starke Ausrichtung der Schichtteilchen aufweisen, wobei die c-Achse (längste Achse senkrecht zur Schichtstruktur) jedes Teilchens sich parallel zum Magnetfeld während des Abscheidevorganges ausrichtet. Die Vorteile einer aus ausgerichteten Teilchen hergestellten Schicht beruhen auf der starken Anisotropie der physikalischen Eigenschaften der oxidischen Supraleiter. So ist z. B. die normale elektrische Leitfähigkeit in Richtung der c-Achse gegenüber Richtungen in der Ebene senkrecht zur c-Achse bei $YBa_2Cu_3O_{7-x}$ um einen Faktor von etwa 60 geringer. Ferner ist die Kohärenzlänge in Richtung der c-Achse 5 bis 7 mal kleiner, die Eindringtiefe 5 bis 7 mal größer als in Richtungen senkrecht dazu. Insgesamt ergibt sich aus dieser Anisotropie im Hinblick auf die Erzielung optimaler Supraleitereigenschaften (hohe Stromdichten, geringe Hochfrequenzverluste) die Bedeutung der Herstellung von Supraleiterschichten mit c-Achsen-Orientierung, da sowohl eine erhöhte Stromleitfähigkeit als auch eine vergrößerte Hochfrequenz-Eindringtiefe erzielt wird. Bei verschiedenen in einem Magnetfeld von etwa 8 Tesla abgeschiedenen $YBa_2Cu_3O_{7-x}$-Schichten auf Silberscheiben (Durchmesser 24 mm, Dicke 0,5 mm) konnte die Existenz der Vorzugsorientierung mit Hilfe der Röntgenbeugung nachgewiesen werden. Der 005-Reflex der bisher besten erfindungsgemäßen Schichten war gegenüber dem bei unorientierten Schichten dominanten 103/110-Reflex um den Faktor von mindestens 14 größer. Die Sprungtemperatur betrug erwartungsgemäß etwa 93 K. Die Hochfrequenz-Eigenschaften dieser Schicht und anderer Schichten wurden bei 21,5 GHz untersucht. Alle magnetisch texturierten Schichten wiesen im Vergleich zu ohne Magnetfeld abgeschiedenen Schichten deutlich geringere Hochfrequenzverluste im gesamten Temperaturbereich zwischen 4.2 und 300 K auf - nicht nur im Temperaturbereich der Supraleitung, sondern auch darüber. Die Bestprobe zeigte z. B. bei 100 K einen Oberflächenwiderstand von 330 mOhm, was einem spezifischen Widerstand von 130 µOhmcm entspricht. Dieser geringe Wert läßt sich nur durch die Verbesserung der Leitungseigenschaften aufgrund der Texturierung erklären. Ferner zeigen magnetisch texturierte Proben eine deutlich schwächere Abnahme der Sprungtemperatur in externen Magnetfeldern als unorientierte Schichten. Dieses Ergebnis demonstriert die überlegene magnetische Abschirmwirkung erfindungsgemäß texturierter Proben.

Der Anwendungsbereich entsprechender Schichten umfaßt

a) elektromagnetische Abschirmungen (gegen quasi-statische Magnetfelder sowie elektromagnetische Wechselfelder),

b) großflächige Mikrowellenbauteile, wie z. B. Hohlraum-Resonatoren hoher Stabilität (z. B. koaxial belastete Resonatoren für den Einsatz in einem für ein Frequenz- bzw. Zeitstandard geeigneten Wasserstoffmaser),

c) miniaturisierte Mikrowellenbauteile wie z. B. Oszillatoren mit verbessertem Phasenrauschspektrum und schmalbandige Filter,

d) dispersionsfreie Leitungen, d. h. Leitungen, bei denen die Signalübertragungsgeschwindigkeit frequenzunabhängig ist,

e) Bänder mit hoher Transportstromdichte.

Im Bereich der beiden Anwendungen a und b gibt es zur Zeit kein anderes vergleichbares Beschichtungsverfahren. Mit der gegenwärtigen Qualität der Schichten lassen sich supraleitende Mikrowellenkomponenten fertigen, deren Eigenschaften bis ungefähr 20 GHz denen von auf Cu basierenden Bauteilen überlegen sind.

Darüber hinaus eignet sich das Verfahren zur strukturierten Abscheidung z. B. auf vorher mit Leiterbahnen versehenen versilberten dielektrischen Substraten.

Die Texturierung kann auch durch den Sinterprozeß kontrolliert und positiv gestaltet werden, da ein im Magnetfeld ablaufender Sinterprozeß mit anschließender Abkühlung im Magnetfeld zu einer verstärkten Texturierung der gesinterten Schicht führen kann. Ein Abkühlen der gesinterten Schicht in reinem Sauerstoff ergibt außerdem besonders gute Schichten.

Durch den Einfluß eines starken Magnetfeldes am Abscheidungsort während des Abscheidevorganges wird erfindungsgemäß eine Ausrichtung der abgeschiedenen Teilchen erreicht. Ein solches Magnetfeld, dessen Stärke etwa 2 Tesla bis etwa 10 Tesla, vorzugsweise zwischen etwa 6 Tesla und etwa 8 Tesla, betragen sollte, kann beispielsweise durch supraleitende Helmholtz-Spulen erzeugt werden. Moderate, auch mit normalen Elektro- oder sogar Permanentmagneten erzeugte Magnetfelder können grundsätzlich auch zu einer Ausrichtung der Teilchen führen. Das Magnetfeld läßt sich in solchen Fällen auch lokal bezüglich der zu beschichtenden Oberfläche ausrichten; gegebenenfalls kann ein "abtastendes" lokales Abscheiden im Magnetfeld realisiert werden.

Durch geeignete Orientierung des Magnetfeldes relativ zu der Oberfläche, auf die die keramische Schicht abzuscheiden ist, läßt sich nahezu jede gewünschte Orientierung der c-Achsen der Schichtteilchen bezüglich der Oberfläche erreichen. Zur Verbesserung der elektrischen Eigenschaften der Schichten ist die Ausrichtung der c-Achsen senkrecht zur Richtung des bei der jeweiligen Anwendung durch die Schicht fließenden Stromes von besonderer Bedeutung, wie bereits ausgeführt. In der Regel ist dementsprechend eine Ausrichtung der c-Achsen der Schichtteilchen senkrecht zur Oberfläche eine gute Wahl; falls die zu beschichtende Oberfläche gekrümmt ist, können jedoch auch andere Vorzugsorientierungen günstig sein. Im Falle von Oberflächen, die relativ zu einer Achse axialsymmetrisch sind und mit elektrischen Strömen zu beaufschlagen sind, die im wesentlichen um die Achse herum verlaufen (dies ist z. B. bei Hohlraumresonatoren der Fall), ist im allgemeinen eine Orientierung der c-Achsen parallel zur Zylinderachse vorteilhaft. Die Vorteile einer Texturierung einer supraleitfähigen Schicht durch lokale Vorzugsorientierung der c-Achsen der Schichtteilchen sind allgemein auch bei gekrümmten Substraten gegeben.

Zur Abscheidung der keramischen Schicht wird günstigerweise das Material in einer organischen, nicht elektrisch leitfähigen Flüssigkeit abgeschieden. Besonders bewährt hat sich Aceton; dabei erfolgt die Abscheidung des in Aceton suspendierten keramischen Materials vorzugsweise bei Temperaturen um etwa -10 °C, da die Anisotropien des Materials, die zu der Ausrichtung der Teilchen führen, um so ausgeprägter sind, je tiefer die Temperatur ist.

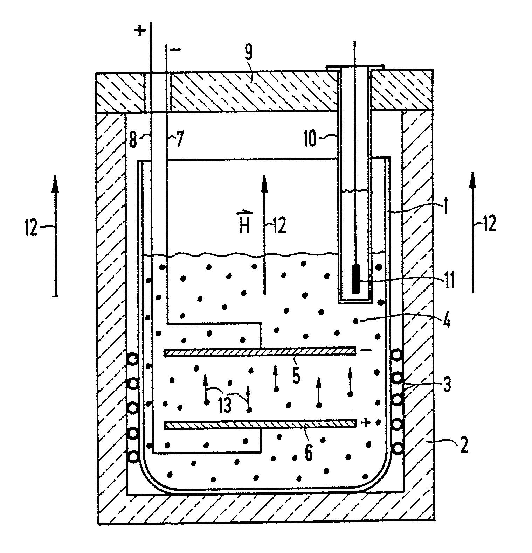

Die Figur zeigt eine elektrophoretische Beschichtung in Laborausführung. Das innere Gefäß 1 ist in einem isolierten äußeren Gefäß 2 angeordnet mit einer Heizwendel 3 dazwischen. In einer Suspension 4 ist eine Kathode 5 und eine Anode 6 angeordnet, deren elektrische Anschlüsse 7 und 8 durch einen ebenfalls isolierten Deckel 9 nach außen geführt sind. In einem Schutzrohr 10 ist ein Thermometer 11 angeordnet. Mit den dicken Pfeilen 12 ist die Richtung eines außen angelegten Magnetfeldes angedeutet. Die kleinen Pfeile 13 zeigen die Bewegungsrichtung der suspendierten Teilchen aufgrund eines elektrischen Feldes.

## Ansprüche

1. Verfahren zur elektrophoretischen Abscheidung einer supraleitfähigen keramischen Schicht aus einem feingemahlenen Material, insbesondere einer $YBa_2Cu_3O_{7-x}$-Schicht, auf einer elektrisch leitfähigen, vorzugsweise metallischen Oberfläche, wobei die Schicht anschließend in oxidierender Atmosphäre gesintert und abgekühlt wird, **dadurch gekennzeichnet**, daß das Material unter Einfluß eines äußeren Magnetfeldes auf der Oberfläche abgeschieden wird.

2. Verfahren nach Anspruch 1, **dadurch gekennzeichnet**, daß auch beim Sintern und Abkühlen ein Magnetfeld angelegt wird.

3. Verfahren nach Anspruch 1 oder 2, **dadurch gekennzeichnet**, daß das Magnetfeld eine Stärke von 2 bis 10 Tesla, vorzugsweise etwa 6 bis 8 Tesla, hat.

4. Verfahren nach Anspruch 1, 2 oder 3, **dadurch gekennzeichnet**, daß das Magnetfeld etwa senkrecht zu der vorgesehenen Stromrichtung in der Schicht gerichtet ist.

5. Verfahren nach einem der vorhergehenden Ansprüche, **dadurch gekennzeichnet**, daß das Material in einer organischen Flüssigkeit abgeschieden wird.

6. Verfahren nach Anspruch 5, **dadurch ge-** kennzeichnet, daß das Material in Aceton bei Temperaturen von etwa -10 °C abgeschieden wird.

7. Supraleitfähige keramische Schicht, insbesondere bestehend aus $YBa_2Cu_3O_{7-x}$ oder einem ähnlichen Material, auf einem Substrat, **dadurch gekennzeichnet**, daß die die Schicht bildenden Teilchen eine Vorzugsorientierung ihrer c-Achsen aufweisen.

8. Supraleitfähige Schicht nach Anspruch 7, **dadurch gekennzeichnet**, daß das Substrat gekrümmt ist.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | EP-A-0 293 981 (IMI TITANIUM LTD) * Spalte 3, Zeilen 35-38; Spalte 6, Zeilen 8-43 * --- | 1,5 | C 25 D 13/02 H 01 L 39/24 |
| A | GB-A-2 207 128 (CHLORIDE SILENT POWER LTD) --- | | |
| A | EP-A-0 289 412 (IWATA) ----- | | |

**RECHERCHIERTE SACHGEBIETE (Int. Cl.5)**

C 25 D
H 01 L

Der vorliegende Recherchenbericht wurde für alle Patentansprüche erstellt

| Recherchenort | Abschlußdatum der Recherche | Prüfer |
|---|---|---|
| DEN HAAG | 28-05-1990 | NGUYEN THE NGHIEP |